# EUROPEAN PATENT APPLICATION

(11) **EP 4 838 720 A1**
(43) Date of publication of application: **11.11.2026**
(21) Application number: 25736431.5
(22) Date of filing: 05.01.2025
(51) Int. Cl.: H01S 3/0941

(54) **PUMPING MODULE OF VCSEL SIDE-PUMPED SOLID-STATE LASER AND CORRESPONDING SOLID-STATE LASER**

(30) Priority: 05.01.2024 CN 202410018111
(71) Applicant: Beijing Ruitongkeyue Tech Co., Ltd., Beijing 100192 (CN)
(72) Inventor: YING, Yan, Beijing 100192 (CN); HAO, Haihua, Beijing 100192 (CN)
(74) Representative: Wang, Bo
(86) International application number: PCT/CN2025/070631
(87) International publication number: WO 2025/146192

(57) **Abstract**

A pumping module of a VCSEL side-pumped solid-state laser and a corresponding solid-state laser. The pumping module uses a design of pumping in an even number of directions, achieves a symmetrical pumping cavity and a mutual reflection chamber, and improves pumping light distribution uniformity. By means of the high reflectivity characteristic of surfaces of VCSEL chips (2) and a packaging substrate and a heat sink (1) therefor, a design in which no independent reflection chamber is provided and the heat sink (1) is integrated is realized, the structure is simplified, and the symmetry of light spots is improved. In addition, a cooling pipe (4) having a frosted outer surface is introduced, so that the uniformity of light beams is further improved by means of a diffusion mechanism, and reflection on the surfaces of the VCSEL chips (2) is used to compensate for possible loss, thereby ensuring that optical-to-optical efficiency is almost unchanged. By using an eccentric pumping structure and an optimized wavelength distribution of the VCSEL chips (2), the absorption uniformity of a crystal rod (200) is further improved; and the uniformity of light beams can be effectively improved, especially when the diameter of the crystal rod (200) is large. The present invention has the advantages of a simple structure, stable performance and good light spot symmetry.

## Description

### BACKGROUND

### Technical Field

The present invention relates to a pumping module of a vertical-cavity surface-emitting laser (VCSEL) side-pumped solid-state laser, also relates to a solid-state laser including the pumping module, and belongs to the technical field of solid-state lasers.

### Related Art

Compared with a conventional lamp-pumped solid-state laser, a side-pumped solid-state laser using a laser diode bar has advantages such as a compact structure, high luminous efficiency, and stable performance. However, in a high-power all-solid-state laser, a multidirectional side-pumping technology is usually used for a pumping module. Such a design requires a crystal rod and a pumping source to be separately cooled. Consequently, the heat dissipation structure is complex, and it is difficult to achieve miniaturization. Therefore, the pumping module is not suitable for a compact high-power all-solid-state laser. In addition, the existing design of a pumping cavity usually uses an independent reflection cavity assembly. To avoid internal amplification of and damage to an edge-emitting semiconductor laser chip caused by counter-propagation of pump light, a design of pumping in an odd number of directions is usually adopted, such as three directions, five directions, or seven directions. To increase the utilization rate of pump light, a slotted reflection cavity is used in the design, so as to perform secondary reflection and utilization on pump light that passes through the laser crystal once without being absorbed. The structure formed by superimposing the pumping source and the reflection cavity is complex, the reflection efficiency is low, and it is difficult to reduce the radial size.

### SUMMARY

A first technical problem to be solved in the present invention is to provide a pumping module of a VCSEL side-pumped solid-state laser.

Another technical problem addressed by the present invention is to provide a solid-state laser comprising the pumping module.

To achieve the foregoing technical objectives, the present invention uses the following technical solutions:
According to a first aspect of the embodiments of the present invention, a pumping module of a VCSEL side-pumped solid-state laser is provided, including a pumping cavity and a crystal rod. The crystal rod is a working rod of the solid-state laser, and the pumping cavity is arranged around the crystal rod.

The pumping cavity includes a heat sink and pump chips. The heat sink is a hollow cylinder. An even number of mounting surfaces are arranged on an inner surface of the heat sink. The mounting surfaces are flat surfaces and are parallel to an axis of the heat sink. Within a cross section perpendicular to an axis of the crystal rod, projections of the plurality of mounting surfaces form a regular polygon. The mounting surfaces are even in number and include a plurality of pairs of mounting surfaces, each pair consisting of a mounting surface and a counterpart mounting surface arranged directly opposite to each other.

The pump chips are VCSEL chips, which are arranged on the mounting surfaces. Light emission directions of the pump chips located on the mounting surfaces and light emission directions of the pump chips located on the counterpart mounting surfaces are in forward alignment with each other.

According to a second aspect of the embodiments of the present invention, another pumping module of a VCSEL side-pumped solid-state laser is provided, including a pumping cavity and a crystal rod. The crystal rod is a working rod of the solid-state laser, and the pumping cavity is arranged around the crystal rod.

The pumping cavity includes a heat sink and pump chips. The heat sink is a hollow cylinder. An even number of mounting surfaces are arranged on an inner surface of the heat sink. The mounting surfaces are flat surfaces and are parallel to an axis of the heat sink. Within a cross section perpendicular to an axis of the crystal rod, projections of the plurality of mounting surfaces form a regular polygon. The mounting surfaces are even in number and include a plurality of pairs of mounting surfaces, each pair consisting of a mounting surface and a counterpart mounting surface, and the normal directions of the mounting surfaces and the counterpart mounting surfaces are offset from each other.

The pump chips are VCSEL chips which are arranged on the mounting surfaces.

Within the cross section perpendicular to the axis, in the light emission direction of the pump chip located on the mounting surface, the light emission direction and a line passing through the center of the pump chip and the axis center of the crystal rod deviate from each other by a predetermined angle α. The predetermined angle α is such that a distance between a normal line passing through the center of the pump chip on the mounting surface and a normal line passing through the center of the pump chip on the counterpart mounting surface is smaller than the diameter of the crystal rod.

Preferably, the pump chips are top-emitting VCSEL chips.

Preferably, the pumping module further includes a cooling tube. An axis of the cooling tube coincides with the axis of the crystal rod to surround the crystal rod and allow cooling gas or liquid to pass through to cool the crystal rod; and the cooling tube is prepared from a high-light-transmittance material.

Preferably, the cooling tube has a polished outer surface or a frosted outer surface, and a roughness of the frosted outer surface is Ra0.1 to Ra80 µm.

Preferably, the cooling tube has a polished outer surface or a frosted outer surface, and a roughness of the frosted outer surface is Ra0.2 to Ra50 µm.

Preferably, along the axis of the crystal rod, at a plurality of cross sections perpendicular to the axis, a central wavelength difference M of a group of pump chips located at the same cross section and an average central wavelength difference N of different groups of pump chips located at different cross sections satisfy M < N.

Preferably, along the axis of the crystal rod, at a plurality of cross sections perpendicular to the axis, a central wavelength difference M of a group of pump chips located at the same cross section and an average central wavelength difference N of different groups of pump chips located at different cross sections satisfy M < N.

According to a third aspect of the embodiments of the present invention, a solid-state laser is provided, including the foregoing pumping module, an output mirror, and a reflector.

The reflector and the output mirror are located on two opposite sides of the pumping module, and a resonance cavity is formed between the reflector and the output mirror.

The output mirror is arranged in a light emission direction of the resonance cavity, and is configured to output light.

Compared with the existing technology, the pumping module of the VCSEL side-pumped solid-state laser and the corresponding solid-state laser that are provided in the present invention have the following technical effects: First, the pumping module adopts the design of pumping in an even number of directions, thereby implementing symmetric pumping cavities and mutual reflection chambers, thereby enhancing the pump light distribution uniformity. Second, by using high reflectivity characteristics of the surfaces of the VCSEL chips and surfaces of a packaging substrate and the heat sink therefor, a design in which no independent reflection cavity is provided and the heat sink is integrated is implemented; loss of pump light caused by a traditional reflection cavity assembly is avoided; the structure is simplified; and the light spot symmetry is enhanced. In addition, by introducing the cooling tube having the frosted outer surface, a diffusion mechanism is introduced to enhance the uniformity of light beams. Meanwhile, the reflection of the surfaces of the VCSEL chips is used to compensate for a loss possibly caused by the frosted surface, thereby ensuring that optical-to-optical efficiency is almost unchanged. Finally, by using an eccentric pumping structure and an optimized wavelength distribution of the VCSEL chips, the absorption uniformity of the crystal rod is further enhanced. The uniformity of light beams can be effectively improved especially when the diameter of the crystal rod is large. In conclusion, the pumping module and the solid-state laser that are provided in the present invention have significant advantages in aspects such as a simple structure, stable performance, and good light spot symmetry, and the pumping module is particularly suitable for being applied to a high-power all-solid-state laser.

### BRIEF DESCRIPTION OF THE DRAWINGS

FIG. 1A is a schematic diagram of a cross section of a pumping module of a VCSEL side-pumped solid-state laser according to a first embodiment of the present invention;
FIG. 1B is a schematic sectional view in a direction A-A in FIG. 1A, with a crystal rod removed;
FIG. 1C is a schematic sectional view in a direction A-A in FIG. 1A, with a crystal rod;
FIG. 2 is a cross-sectional diagram of distribution of an absorbed pump power when the same cross section of a laser crystal rod is irradiated by five pump light sources in the existing technology;
FIG. 3 is a cross-sectional diagram of distribution of an absorbed pump power when the same cross section of a laser crystal rod is irradiated by six pump light sources according to an embodiment of the present invention;
FIG. 4 is a schematic diagram of a cross-sectional structure of a pumping module of a VCSEL side-pumped solid-state laser according to a second embodiment of the present invention;
FIG. 5 is a schematic diagram of a structure of a solid-state laser including the pumping module according to a third embodiment of the present invention;
FIG. 6 is a schematic diagram of a cross-sectional structure of a pumping module of a VCSEL side-pumped solid-state laser according to a fourth embodiment of the present invention;
FIG. 7 is a diagram of light intensity distribution, in a cross section perpendicular to a crystal rod, of a pumping module of a VCSEL side-pumped solid-state laser in FIG. 4 and FIG. 6;
FIG. 8 is a schematic diagram of comparison between a cross-sectional structure of a pumping module of a VCSEL side-pumped solid-state laser in a fifth embodiment and a cross-sectional structure of a pumping module of a VCSEL side-pumped solid-state laser in a fourth embodiment;
FIG. 9 is a schematic diagram of comparison of light intensity distribution, in a cross section perpendicular to a crystal rod, between a pumping module of a VCSEL side-pumped solid-state laser in a fifth embodiment and a pumping module of a VCSEL side-pumped solid-state laser in a fourth embodiment; and
FIG. 10 is a schematic diagram of a structure of a crystal rod and a pump chip in a pumping module of a VCSEL side-pumped solid-state laser according to a sixth embodiment of the present invention.

### DETAILED DESCRIPTION

Technical contents of the present invention will be described in detail below with reference to the accompanying drawings and specific embodiments.

A technical idea in the embodiments of the present invention is to use a vertical-cavity surface-emitting laser (VCSEL) as a pump light source of a laser crystal rod, and use a VCSEL chip to form a pumping cavity. An electrode material on a surface of the VCSEL chip is gold, a material of a packaging substrate is also gold, and a surface distributed Bragg reflector (DBR) has a reflectivity of 98% or even more than 99%, so that the surface of the VCSEL chip has an extremely high reflectivity for light beams, and can be used as a pump source to emit a light beam. The surface can also be used as a reflection surface, so that the light beam is reflected multiple times in the pumping cavity, to form a laser beam. In addition, since the VCSEL chip is used, and a closed reflection cavity (without a gap) is formed in a manner of surrounding the crystal rod (a working rod), a light beam used as a pump source emerges from a surface of the VCSEL chip facing the crystal rod, passes through the crystal rod, and then reaches the VCSEL chip located directly opposite to it, and is then reflected multiple times. In this way, a gap does not need to be reserved in a reflection cavity in the existing technology to allow incidence of pump light, thereby enhancing the utilization rate of the pump light. Furthermore, by using an even number of VCSEL chips that are symmetrically arranged opposite to each other, the light beam can be completely and symmetrically emitted to the opposite VCSEL chips, and then reflected multiple times, so that the light spot uniformity can be enhanced.

### First Embodiment

A first embodiment of the present invention provides a pumping module of a VCSEL side-pumped solid-state laser, including a pumping cavity 100 and a crystal rod 200 that are coaxially arranged. The pumping cavity 100 is arranged around the crystal rod 200.

The pumping cavity 100 includes a heat sink 1 and pump chips 2. The pump chips 2 are VCSEL chips. Although bottom-emitting VCSEL chips may be used, preferably, the pump chips 2 are top-emitting VCSEL chips.

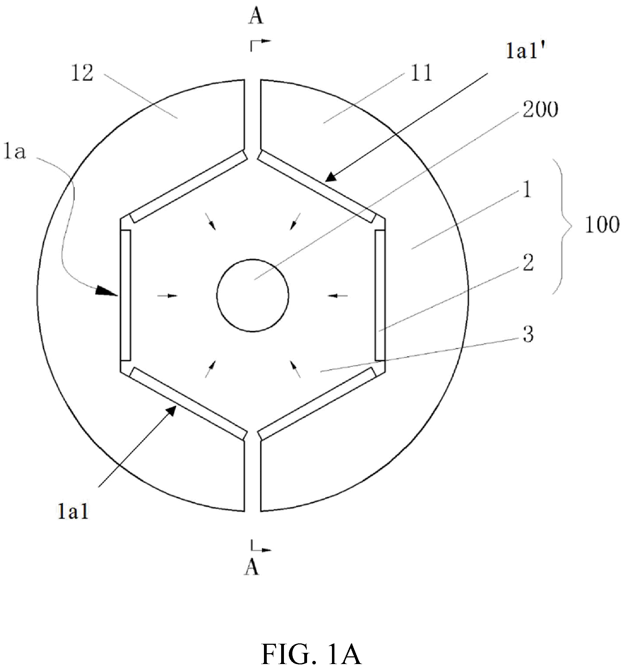

FIG. 1A is a schematic diagram of a cross section of the pumping cavity 100 perpendicular to the axial direction provided in this embodiment. The heat sink 1 is a hollow cylinder provided with an inner cavity, and is an integrally formed structure made of a material (such as silicon carbide and aluminum nitride) that has high thermal conductivity and is easily processed. The heat sink 1 is configured to mount the pump chips 2 and provide heat dissipation for the pump chips 2. Preferably, the heat sink 1 is a structure formed by assembling a plurality of components, for example, two components, three components, or four components. This embodiment is described by using an example in which the heat sink 1 is a structure formed by assembling two components.

The heat sink 1 includes a first assembly 11 and a second assembly 12. The mating surfaces of the first assembly 11 and the second assembly 12 are parallel to an axis (coaxial with the crystal rod) of the heat sink 1, to form the hollow cylinder. A projection of an inner surface of the heat sink 1 on a cross section is a regular polygon. The inner surface of the heat sink 1 includes a plurality of mounting surfaces 1a, and the mounting surfaces 1a are flat surfaces parallel to the axis of the crystal rod 200. The mounting surfaces 1a are arranged in an annular array with a projection of the axis of the heat sink 1 on the cross section as the center.

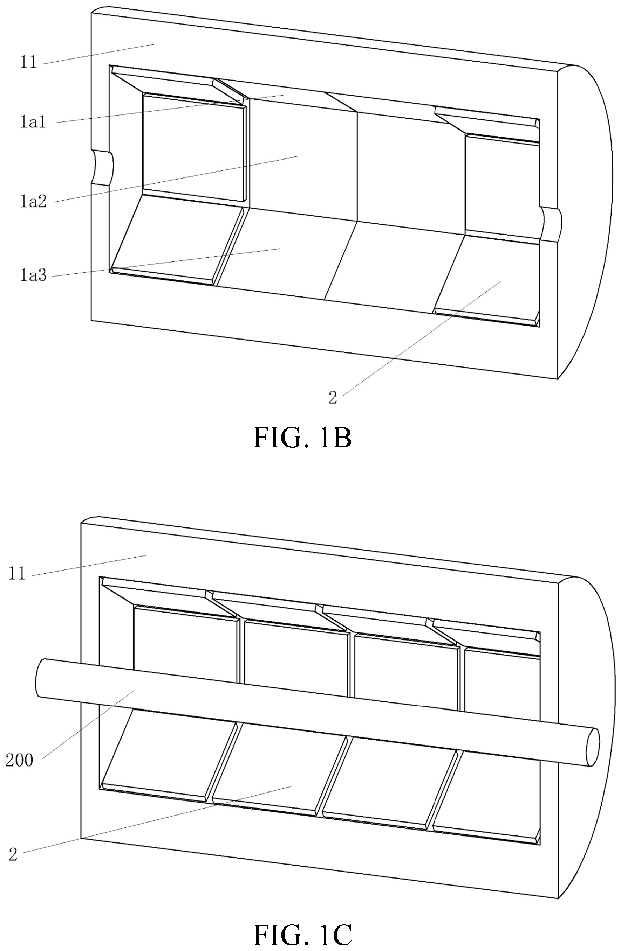

As shown in FIG. 1B, on a cross section of the first assembly 11 perpendicular to the axis of the heat sink 1, one side of a first mounting surface 1a1 is connected to one side of a second mounting surface 1a2, and an angle is formed between the two mounting surfaces. Another side of the second mounting surface 1a2 is connected to one side of a third mounting surface 1a3, and an angle is formed between the two mounting surfaces. The structure of the second assembly 12 is the same as the structure of the first assembly 11. Therefore, in the heat sink 1 formed by assembling the first assembly 11 and the second assembly 12, projections of the mounting surfaces 1a on the cross section perpendicular to the axis of the heat sink 1 form a regular hexagon. In other words, the mounting surfaces are even in number and include a plurality of pairs of counterpart mounting surfaces (e.g., the first mounting surface 1a1 of the first assembly 11 and the counterpart mounting surface 1a1' of the second assembly 12), each pair consisting of a mounting surface and a counterpart mounting surface arranged directly opposite to each other (i.e., in mutual forward alignment). Being arranged directly opposite to each other means that a plane containing the axis of the heat sink 1 has a plane-symmetry feature. In other words, being directly opposite means that the two counterpart mounting surfaces have a plane-symmetry relationship with respect to a plane on which the axis of the crystal rod 200 lies.

In this embodiment, since the heat sink 1 is of the structure assembled by two components, each heat sink 1 has two or more mounting surfaces 1a, to mount a corresponding number of pump chips 2. The shapes and sizes of the mounting surfaces 1a are the same, so that after assembly, the mounting surfaces 1a are symmetrically arranged and directly opposite to each other.

A back surface of the heat sink 1 is a surface opposite to the mounting surfaces, and the shape of the back surface is designed so that the entire assembled heat sink 1 is circular or rectangular, so that heat of the pump chips can be uniformly dissipated. It should be noted that a plurality of pump chips located on the same cross section share one heat sink.

The heat sink 1 and the pump chips 2 enclose to form an inner cavity 3. The inner cavity 3 surrounds the crystal rod 200, and is configured to form a cooling air path or a cooling flow channel.

In this embodiment, since the heat sink 1 is assembled by two components, the inner cavity 3 is closed by the heat sink 1. In addition, the pump chips 2 are located on the mounting surfaces 1a of the heat sink 1, and therefore, a plurality of pump chips 2 on the same cross section are connected to form a closed chip ring. On the whole, the crystal rod 200 is surrounded by a plurality of chip rings. There is no gap between the plurality of pump chips 2 (chip rings) on the same cross section for allowing a light beam to be injected into the crystal rod 200.

Therefore, on a cross section perpendicular to an axis of the pumping cavity 100, the number n of the pump chips 2 arranged in a polygonal-surrounding manner satisfies n ≥ 4. Preferably, n is an even number greater than or equal to 6. In this embodiment, n = 6 is used as an example for description. As shown in FIG. 1C, the pump chips 2 are arranged on the mounting surfaces 1a, and light-emitting surfaces of the pump chips 2 face away from the mounting surfaces 1a. Therefore, the light emission direction of the pump chips 2 located on the mounting surfaces is perpendicular to the axis of the crystal rod 200, and points to the pump chips 2 located on the counterpart mounting surfaces. Since the mounting surfaces are arranged directly opposite to each other, the two pump chips 2 located on the counterpart mounting surfaces are also arranged directly opposite to each other. The pump chips 2 arranged directly opposite to each other have the same performance parameters, and light beams emitted by them are completely symmetrical and reflected, thereby enhancing the pumping efficiency.

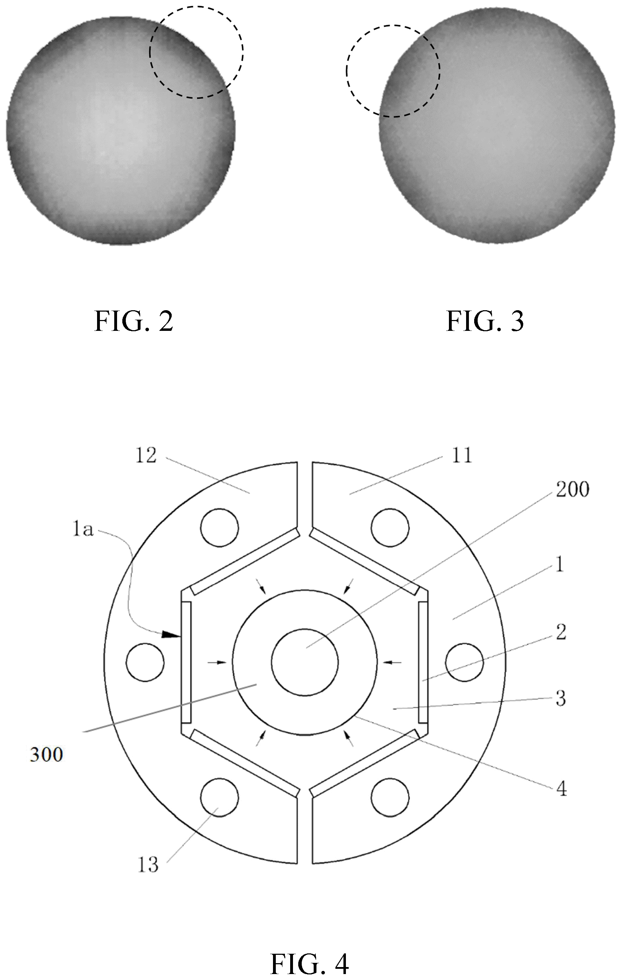

FIG. 2 shows an energy distribution diagram when n is an odd number 5 (referred to as five-directional pumping below, which is the existing technology). FIG. 3 shows an energy distribution diagram when n is an even number 6. It can be seen by comparison that when there are an odd number of pump chips 2 on the same cross section, the pump chips cannot achieve mutual direct incidence, but when there are an even number of pump chips 2, the pump chips can be totally reflected (mutually incident). Therefore, six-directional pumping has better symmetry than five-directional pumping, and the energy distribution is more uniform.

Since the number of the pump chips 2 provided in this embodiment is n = 6, six mounting surfaces 1a are connected end to end, and are arranged in a hexagon with the axis of the heat sink 1 as the center. In addition, since the surface reflectivity of the pump chips 2 is more than 99%, the surface electrode is a gold layer, and the material of the packaging substrate is also a gold layer, the pump chips 2 enclose to form a hexagonal laser reflection cavity which has a good reflection effect. Therefore, according to the pumping cavity 100 provided in this embodiment of the present invention, an independent reflection cavity assembly and a lighttransmitting window-type reflection cavity assembly do not need to be provided, so that a reflection cavity can be formed by using the pump chips 2 and the heat sink 1, thereby avoiding loss of pump light by the independent reflection cavity assembly. In addition, mutual reflection occurs between an even number of pump chips, so that the overall energy distribution is more uniform.

### Second Embodiment

This embodiment is based on the first embodiment, but differs from the first embodiment in that: the pumping cavity 100 provided in this embodiment further includes a cooling tube (also referred to as a glass flow tube) 4, and the heat sink 1 further includes a plurality of cooling holes 13. The plurality of cooling holes 13 are formed in the heat sink 1, and extend in a direction of the axis of the heat sink 1 (which is also the axis of the crystal rod 200).

As shown in FIG. 4, the cooling holes 13 are located between the mounting surfaces 1a and an outer surface of the heat sink 1, and are configured to form a cooling air path or a cooling flow channel for cooling liquid, to provide heat dissipation and cooling for the heat sink 1.

The cooling tube 4 is located in the inner cavity 3, and extends in the direction of the axis of the crystal rod 200. The axis of the cooling tube 4 coincides with the axis of the heat sink 1, to surround the crystal rod 200 and form a cooling flow channel for a cooling medium 300, so as to provide heat dissipation and cooling to the crystal rod 200. Preferably, the cooling tube 4 is an integrally formed structure made of a high-light-transmittance material such as optical glass or quartz, and has a conventional polished outer surface (for example, a surface roughness less than Ra0.2 µm, or less than Ra0.1 µm).

To verify the technical effect of the present invention, experimental verification was performed using the second embodiment. Using the six-directional pumping Nd:YAG module of the present invention as an example, an Nd:YAG crystal was used as the crystal rod 200. The Nd:YAG crystal had a diameter of 5 mm, a length of 90 mm, and an Nd doping concentration of 1%. 48 808 nm VCSEL chips were used as the pump chips 2. The VCSEL chips were divided into eight circumferences (six VCSEL chips forming one circumference) to surround the crystal rod 200. The test conditions were as follows: (1) The working power of the VCSEL chips was 120 W, and the working duration was 1 ms. (2) A 250 mm plane-plane resonator was used. (3) The transmittance T of the output mirror was 20%. (4) The temperature of the cooling water was 25°C. A 1064 nm laser output with a single pulse energy of 2.2 J (1 ms, 10 Hz) was obtained. The optical-to-optical efficiency = 2.2/(120 × 48 × 0.001) = 38.2%. The optical-to-optical conversion efficiency of the pumping module was basically the same as that of a pumping module with a reflection cavity.

### Third Embodiment

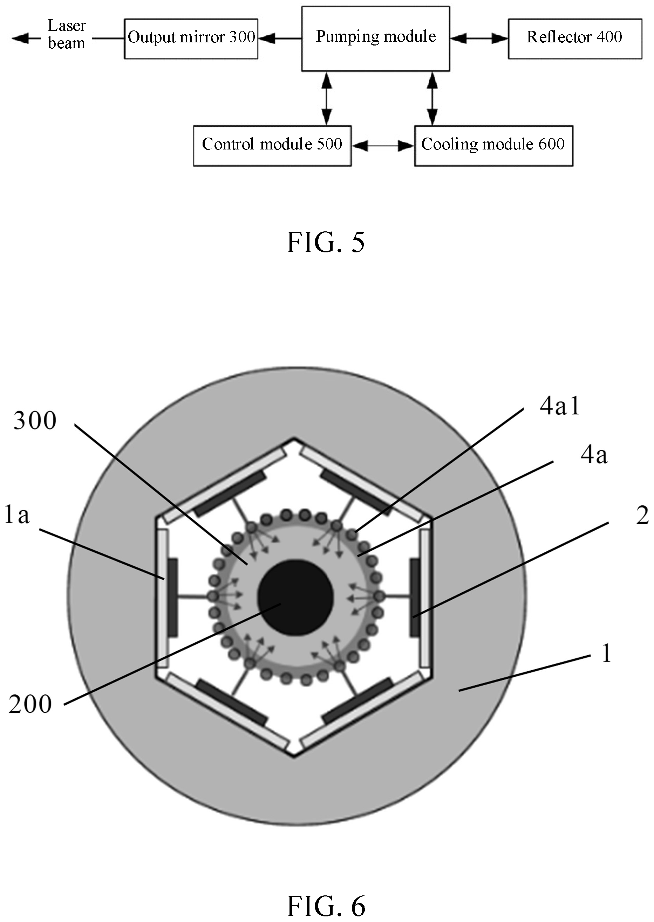

This embodiment provides a solid-state laser including the foregoing pumping module. As shown in FIG. 5, the solid-state laser includes an output mirror 300, a pumping module (which includes the pumping cavity 100 and the crystal rod 200), a reflector 400, and may further include a control module 500 and a cooling module 600.

The output mirror 300, the pumping module, and the reflector 400 are sequentially arranged coaxially, and the pumping cavity 100 surrounds the crystal rod 200. The reflector 400 and the output mirror 300 are located on two opposite sides of the pumping module, and a resonance cavity is formed between them. In other words, the pumping cavity 100 surrounds the crystal rod 200. The reflector 400 is arranged in a direction opposite to the light emission direction of the crystal rod 200, and is arranged coaxially with the crystal rod 200. A reflection surface of the reflector 400 is perpendicular to the axis of the crystal rod 200. The output mirror 300 is arranged in the light emission direction of the crystal rod 200, and is arranged coaxially with the crystal rod 200.

Light exiting from the crystal rod 200 in the reverse direction reaches the reflector 400, is reflected back to the crystal rod 200, and exits from the crystal rod 200 in the forward direction. The light exiting from the crystal rod 200 in the forward direction reaches the output mirror 300, and exits through the output mirror 300.

The cooling module 600 is connected to a cooling air path or a cooling flow channel of the pumping cavity 100, inputs cooling air or cooling liquid to the pumping cavity 100, and receives cooling air or cooling liquid that is heated by the pumping cavity 100.

The control module 500 is connected to the pumping cavity 100 and the cooling module 600, receives parameters such as the energy of the output laser beam and the temperature of the pumping cavity 100, and controls parameters of the pumping cavity 100 such as input current, voltage, and flow rate of the cooling medium based on these parameters, so that the pumping module stably outputs the laser beam.

In the experimental verification performed in the second embodiment, the transmittance T of the output mirror 300 was 20%, and the length of the resonance cavity formed by the reflector 400 and the output mirror 300 was 250 mm. The temperature of the cooling water of the cooling module 600 was 25°C, and a 1064 nm laser output with a single pulse energy of 2.2 J (1 ms, 10 Hz) was obtained.

### Fourth Embodiment

Unlike the cooling tube 4 in the second embodiment, whose inner and outer surfaces are both polished (so that they are smooth surfaces and have a roughness of Ra0.1 µm or less), a cooling tube 4a in this embodiment has a tubular structure with a frosted outer surface and a smooth inner surface. The remaining structures in this embodiment are the same as those in the second embodiment, and therefore are not elaborated herein. The roughness of the outer surface 4a1 of the cooling tube 4a is Ra0.1 µm to Ra80 µm, more preferably Ra0.2 µm to Ra50 µm, Ra0.5 µm to Ra35 µm, Ra1 µm to Ra25 µm, or Ra1 µm to Ra15 µm. For example, the outer surface 4a1 of the cooling tube 4a is obtained by grinding with an abrasive material such as diamond, silicon carbide, or boron carbide of 50 to 240 mesh (more preferably 60 to 200 mesh or 100 to 140 mesh).

It is well known that pump light is usually 808 nm, and the interface loss between air and glass most significantly affects the optical-to-optical efficiency. Usually, the outer surface (the interface between air and glass) of the cooling tube has a loss of approximately 4%, and the inner surface (the interface between water and glass) also has a loss which is slightly less than that of the outer surface. The interface loss between air and glass usually increases as the roughness of the glass surface increases (i.e., as the surface changes from a polished surface to a frosted surface). This is also the reason why the cooling tube for water cooling on the crystal rod usually has a polished outer surface.

Therefore, in an embodiment of the present invention, the loss is reduced by using the reflection function of the surfaces of the VCSEL chip ring. As shown in FIG. 6, the frosted surface of the cooling tube 4a diffuses the pump light beam, and provides diffuse transmission and reflection for the pump light beam. The diffuse transmission significantly improves the uniformity of absorption of the crystal rod in the primary transmission process of the pump light beam. On one hand, most of the pump energy is absorbed when the light beam emitted by the VCSEL chips passes through the crystal rod for the first time. On the other hand, since the diffuse-transmitted and reflected light beam is reflected again by the surfaces of the VCSEL chips (for example, a metal layer such as a copper or gold layer formed by vapor deposition), and re-enters the crystal rod, the additional loss caused by the frosted surface compared with the polished surface is negligible, and the pumping efficiency (optical-to-optical efficiency) is hardly affected. Therefore, the cooling tube 4a having the frosted outer surface can enhance the symmetry and uniformity of the laser output without reducing (or hardly reducing) the optical-to-optical efficiency.

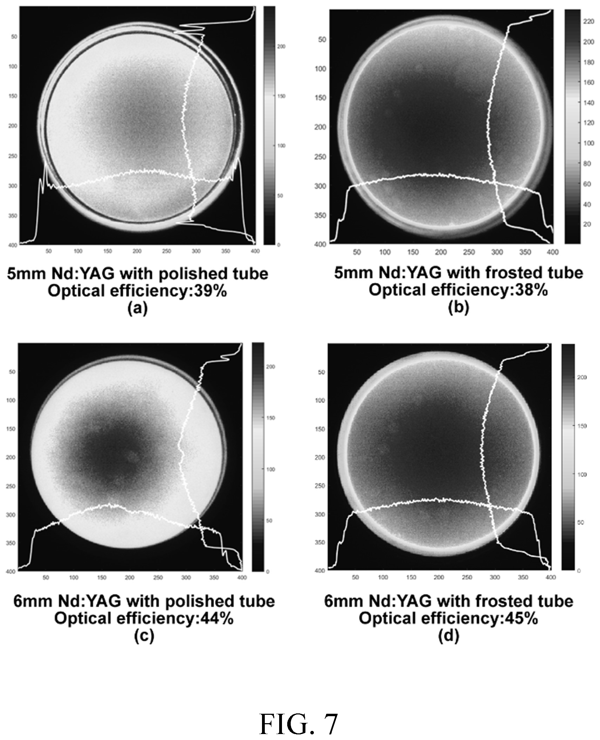

FIG. 7 provides light intensity distributions at the output end faces of Nd:YAG lasers with polished tubes and frosted tubes, to prove that the optical-to-optical efficiency of the pumping module provided in this embodiment is the same as or basically the same as that of a conventional design, while the light uniformity and symmetry are both enhanced. FIG. 7 shows that the optical-to-optical efficiency of a 5 mm diameter Nd:YAG laser with a polished tube is 39%; the optical-to-optical efficiency of a 5 mm diameter Nd:YAG laser with a frosted tube is 38%; the optical-to-optical efficiency of a 6 mm diameter Nd:YAG laser with a polished tube is 44%; and the optical-to-optical efficiency of a 6 mm diameter Nd:YAG laser with a frosted tube is 45%. It can be seen that for Nd:YAG lasers with different diameters, whether the cooling tube has a polished or frosted outer surface, their optical-to-optical efficiencies are almost the same.

In addition, FIG. 7 also shows that when the cooling tube 4a has a frosted outer surface, the proportion of the high-temperature region at the center of the crystal rod 200 is larger, and the distribution of the high-temperature region is more uniform. It is also observed that the brightness of the surface of the Nd:YAG crystal rod using the frosted tube is also reduced. Since no significant difference in optical-to-optical efficiency was observed, this means that replacing the polished outer surface of the cooling tube 4 with the frosted outer surface does not cause any loss in optical-to-optical efficiency.

The experimental conditions for the foregoing verification were as follows: In the six-directional pumping Nd:YAG module shown in FIG. 6, an Nd:YAG crystal with a doping concentration of 0.8% was used as the crystal rod, with diameters of 5 mm and 6 mm, and a length of 90 mm. 48 808 nm VCSEL chips were used as the pump chips. The VCSEL chips were divided into eight circumferences (six VCSEL chips forming one circumference) to surround the crystal rod 200. The distance from the chip surface of each pump chip to the center of the Nd:YAG crystal rod 200 was 9.5 mm. The central wavelengths of all the VCSEL pump chips had a deviation of ±0.5 nm. For both the frosted tube and the polished tube, the outer diameter was 10 mm and the inner diameter was 8 mm. The frosted surface was made using 120 mesh diamond.

### Fifth Embodiment

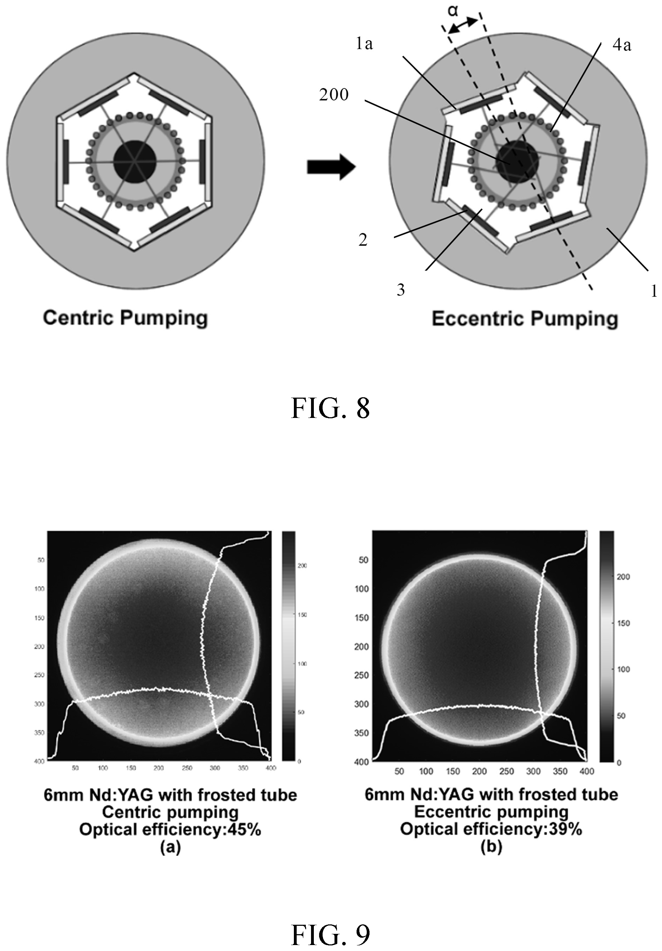

Different from the first embodiment, the light emission direction of the VCSEL chip in this embodiment is not oriented to the pump chip located on the counterpart mounting surface, but deviates by a predetermined angle. Herein, this structure is referred to as an "eccentric pumping" structure. FIG. 8 compares the difference between the light emission direction of the VCSEL chip in the third embodiment and that in the fourth embodiment. As shown in the figure, on a cross section perpendicular to the crystal rod, the light emission direction of the center of symmetry of the VCSEL chip in the third embodiment passes through the axis center of the crystal rod 200 (referred to as "centric pumping" structure). The light emission direction of the center of symmetry of the VCSEL chip in the fourth embodiment does not pass through the axis center of the crystal rod 200. The light emission directions of the centers of symmetry of all the VCSEL chips form a radiation-symmetric structure around the axis center.

Specifically, as shown in FIG. 8, the pumping module of the VCSEL side-pumped solid-state laser in this embodiment includes a pumping cavity 3 and a crystal rod 200. The crystal rod 200 is a working rod of the solid-state laser. The pumping cavity 3 is arranged around the crystal rod 200. The pumping cavity 3 includes a heat sink 1 and pump chips 2 (top-emitting VCSEL chips). The heat sink 1 is a hollow cylinder. Mounting surfaces 1a are arranged on an inner surface of the heat sink. The mounting surfaces 1a are flat surfaces and are parallel to the axis of the heat sink 1. Within a cross section perpendicular to the axis of the crystal rod 200, projections of the plurality of mounting surfaces 1a form a regular polygon. Moreover, within the cross section perpendicular to the axis, the mounting surfaces are even in number and include a plurality of pairs of mounting surfaces, each pair consisting of a mounting surface and a counterpart mounting surface arranged opposite to each other. The normal directions of the mounting surfaces and the counterpart mounting surfaces are parallel to each other and are perpendicular to the axis of the crystal rod. The pump chips are VCSEL chips which are arranged on the mounting surfaces. Within the cross section perpendicular to the axis, in the light emission directions of the pump chips located on the mounting surfaces, a line passing through the center of a pump chip and the axis center of the crystal rod deviates from a line passing through the center of the counterpart pump chip and the axis center by a predetermined angle α. The predetermined angle α is such that a distance between a normal line passing through the center of the pump chip on the mounting surface and a normal line passing through the center of the pump chip on the counterpart mounting surface is smaller than the diameter of the crystal rod. In other words, each mounting surface 1a is rotated about its own central axis (parallel to the axis of the heat sink 1) by a predetermined angle α. For example, the mounting surfaces 1a are rotated by 8° clockwise about their own central axes. Therefore, the light emission directions of the pump chips 2 change from a centric arrangement pointing to the axis of the crystal rod 200 (in the third embodiment) to an eccentric arrangement pointing to one side of the axis of the crystal rod 200 (in the fourth embodiment). That is, the centric pumping structure is changed into the eccentric pumping structure. Technical details not described in this embodiment are the same as those in the first embodiment, and are not repeated herein.

As shown in FIG. 9, the eccentric pumping structure further enhances the uniformity. For the pumping module used in the experiment shown in FIG. 7, having the 6 mm diameter crystal rod and the frosted tube, when the pumping module adopts the centric pumping structure, the optical-to-optical efficiency is 45%; when it adopts the eccentric pumping structure, the optical-to-optical efficiency is 39%.

However, in the eccentric pumping structure, the concentration of the high-temperature region at the center of the crystal rod is reduced, and the absorption at the edge of the Nd:YAG crystal rod is enhanced. This is because in the eccentric pumping structure, a plurality of pump light beams are not directly irradiated on the axis center of the crystal rod, but are irradiated on the edge of the crystal rod, forming a ring surrounding the axis center. This changes the distribution of the laser beam, so that the absorption at the edge of the crystal rod is enhanced, resulting in a distribution where the light intensity at the edge is increased and the light intensity at the center is decreased. Especially in the case where the diameter of the crystal rod (for example, the diameter is greater than or equal to 8 mm) is much larger than the length of the pump light beam path, it is difficult to enhance the uniformity with conventional technology. However, by using the eccentric pumping structure, the beam profile can be changed from a Gaussian-like distribution to a flat-top distribution, thereby enhancing the uniformity. Therefore, when the diameter of the crystal rod is relatively large, the eccentric pumping structure is preferentially used to enhance the uniformity.

Although this embodiment describes the pumping structure having the frosted tube, the pumping structure having the polished tube in the first embodiment can still enhance the uniformity by using the eccentric pumping structure. Details are not repeated herein. In other words, the pumping structures of the first to fourth embodiments can all use the eccentric pumping structure to further enhance the uniformity.

### Sixth Embodiment

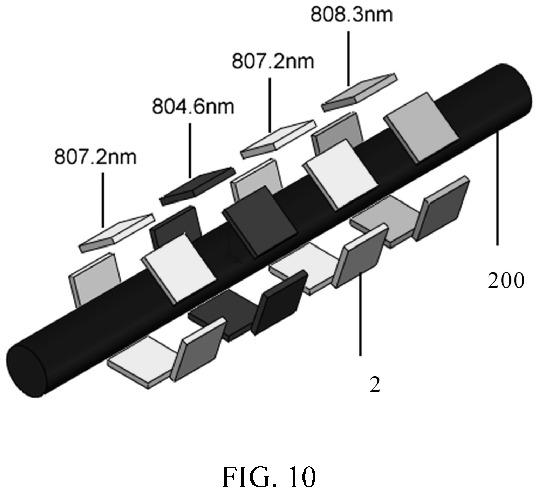

As shown in FIG. 10, based on any one of the first to fifth embodiments, this embodiment further optimizes the design of the pumping module. In any pumping module of the foregoing embodiments, in a group of annularly arranged pump chips (VCSEL chips) distributed on each cross section perpendicular to the axial direction of the crystal rod, the central wavelengths of the laser diodes of the pump chips are close to each other (for example, a central wavelength difference of less than 1 nm, or even 0.5 nm). In other words, the central wavelength difference of each group of pump chips in the pumping modules of the first to fifth embodiments is not limited; however, in this embodiment, the central wavelength difference of each group of pump chips is made as small as possible, and the central wavelength differences between different groups may be the same or different.

Specifically, in the pumping module of the VCSEL side-pumped solid-state laser in this embodiment, a plurality of groups of pump chips are arranged in the axial direction of the crystal rod. All laser diodes in the pump chips operate at a single wavelength. On a plane perpendicular to the axial direction and passing through the center, projections of each group of pump chips are arranged in a ring with radial symmetry, centered on the axis center of the crystal rod. All the laser diodes of the group of pump chips (VCSEL chips) have the same or similar optical power and spectral characteristics. Since the crystal rod has different absorption levels for different wavelengths, the pumping efficiency of the Nd:YAG crystal rod is very sensitive to the wavelength distribution of the laser diodes. To achieve effective absorption of the Nd:YAG crystal rod (to increase the absorption rate), the laser diodes are usually designed to have a central wavelength of 804 nm to 809 nm, so as to match the absorption peak of the Nd:YAG crystal rod. However, in the cross section and axial direction of the Nd:YAG crystal rod, wavelength deviations among the laser diodes in these two directions can cause a decrease in the output uniformity of the Nd:YAG crystal rod. The central wavelengths of the laser diodes need to match the diameter and doping level of the Nd:YAG crystal rod, so that an appropriate pump light beam path length can be designed in advance. For a relatively large diameter or a relatively high doping level, a pumping wavelength with a relatively low absorption rate is required (i.e., the pumping wavelength deviates from the absorption peak). For a relatively small diameter or a relatively low doping level, it is more desirable to make the pumping wavelength as close to the absorption peak as possible. Optimally, all the pump chips have the same or nearly the same wavelengths (for example, a central wavelength difference of less than 1 nm, or even less than 0.5 nm).

However, when the optimum solution cannot be achieved for various reasons, another feasible alternative is as follows: In the axial direction of the crystal rod, in each group of pump chips on a cross section perpendicular to the axial direction, the pump chips have the same or nearly the same central wavelengths (for example, a central wavelength difference of less than 1 nm, or even less than or equal to 0.5 nm); and the wavelength difference between different groups of pump chips is greater than 1 nm (but the pump light beam path length must also be considered, so the difference should not be too large, for example, not exceeding 5 nm, and preferably not exceeding 3 nm). In other words, the central wavelength difference M of the same group of pump chips and the average central wavelength difference N of different groups of pump chips satisfy M < N. The central wavelength difference M of the same group of pump chips refers to the difference between the wavelength of the pump chip having the maximum wavelength and that of the pump chip having the minimum wavelength in the same group. The average central wavelength difference N between different groups of pump chips refers to the difference between the average value of the wavelengths of the pump chips in a first group and the average value of the wavelengths of the pump chips in a second group. The first group and the second group are respectively located on different cross sections perpendicular to the axial direction of the crystal rod.

For example, at the current industrial level, the central wavelength error of semiconductor laser chips is usually controlled within +/-3 nm. Therefore, to increase the chip utilization rate (from an economic perspective), it can be required that the central wavelength error of the same group of VCSEL chips (in the same circle in FIG. 10) is within +/-0.5 nm (M = 0.5 nm), and the wavelength difference between different groups is within +/-3 nm (N = 3 nm). Meanwhile, the central wavelengths of all VCSEL chips should be within the high-efficiency absorption range of the crystal rod (for an Nd:YAG crystal rod, the central wavelengths of all VCSEL chips are required to be in the range of 803 nm to 809 nm). For example, in the figure, the wavelength of a first group of VCSEL chips is 807.2 nm; the wavelength of a second group is 804.6 nm; the wavelength of a third group is 807.2 nm; and the wavelength of a fourth group is 808.3 nm. In this case, the optical power of the laser diodes is controlled according to the same rule. Since the wavelengths of each group of pump chips are close to each other, the output uniformity of the solid-state laser is enhanced.

In conclusion, according to the pumping module of the VCSEL side-pumped solid-state laser and the corresponding solid-state laser provided in the embodiments of the present invention, by adopting an even number of pumping directions, symmetric pumping cavities and mutual reflection chambers are implemented, thereby enhancing the pump distribution uniformity. Meanwhile, by using the high reflectivity characteristics of the surfaces of the VCSEL chips and/or the surfaces of the packaging substrate and the heat sink, a pumping module with no independent reflection cavity, an integrated heat sink, and mutually incident pump light is achieved, so that loss of pump light caused by an independent reflection cavity assembly is avoided. The solid-state laser has the characteristics of a simple structure, good light spot symmetry, and the like. In the solid-state laser provided in this embodiment, the output of the solid-state laser is achieved by using the reflector and the output mirror; cooling is performed by using the cooling module; and the input and output capabilities of the solid-state laser are controlled by using the control module.

Further, in the pumping module and the corresponding solid-state laser provided in the embodiments of the present invention, the cooling tube having the frosted outer surface is used to introduce a diffusion mechanism, to enhance uniformity. The loss caused by the frosted outer surface is compensated by the surface reflection of the VCSEL chips, thereby achieving nearly unchanged optical-to-optical efficiency of the pumping module (compared with the pumping module having the same structure but with a polished cooling tube).

Further, by using the eccentric pumping structure, the absorption at the edge of the crystal rod is enhanced, thereby improving uniformity.

Still further, due to the arrangement of the VCSEL chips in the axial direction and on the cross sections, the wavelength distribution of each group of VCSEL chips surrounding the crystal rod is made more uniform, thereby improving uniformity.

It should be noted that the above embodiments are described for illustrative purposes only. The technical solutions of the embodiments may be combined, all of which fall within the protection scope of the present invention.

The terms "first" and "second" are used for descriptive purposes only and are not to be construed as indicating or implying relative importance or implicitly indicating the number of technical features indicated. Thus, features defined as "first" and "second" may explicitly or implicitly include one or more of the features. In the description of the present application, "plurality" means two or more, unless otherwise expressly and specifically defined.

The pumping module of the VCSEL side-pumped solid-state laser and the corresponding solid-state laser provided in the present invention have been described in detail. For those of ordinary skill in the art, any obvious changes made to the present invention without departing from its essential content will constitute infringement of the patent rights of the present invention, and they will bear corresponding legal responsibilities.

## Claims

1. A pumping module of a vertical-cavity surface-emitting laser (VCSEL) side-pumped solid-state laser, comprising a pumping cavity and a crystal rod, wherein
the crystal rod is a working rod of the solid-state laser, and the pumping cavity is arranged around the crystal rod;
the pumping cavity comprises a heat sink and pump chips; the heat sink is a hollow cylinder; an even number of mounting surfaces are arranged on an inner surface of the heat sink; the mounting surfaces are flat surfaces and are parallel to an axis of the heat sink; within a cross section perpendicular to an axis of the crystal rod, projections of the plurality of mounting surfaces form a regular polygon; the mounting surfaces are even in number and include a plurality of pairs of mounting surfaces, each pair consisting of a mounting surface and a counterpart mounting surface arranged directly opposite to each other;
the pump chips are VCSEL chips, which are arranged on the mounting surfaces; and light emission directions of the pump chips located on the mounting surfaces and light emission directions of the pump chips located on the counterpart mounting surfaces are in direct alignment with each other.

2. The pumping module according to claim 1, wherein
the pump chips are top-emitting VCSEL chips.

3. The pumping module according to claim 2, further comprising a cooling tube, wherein
an axis of the cooling tube coincides with the axis of the crystal rod to surround the crystal rod and allows cooling gas or liquid to pass through to cool the crystal rod; and the cooling tube is made of a high-light-transmittance material.

4. The pumping module according to claim 3, wherein
the cooling tube has a polished outer surface or a frosted outer surface, and a roughness of the frosted outer surface is Ra0.1 to Ra80 µm.

5. The pumping module according to claim 3, wherein
the cooling tube has a polished outer surface or a frosted outer surface, and a roughness of the frosted outer surface is Ra0.2 to Ra50 µm.

6. The pumping module according to claim 2, wherein
along the axis of the crystal rod, at a plurality of cross sections perpendicular to the axis, a central wavelength difference M of a group of pump chips located at the same cross section and an average central wavelength difference N of different groups of pump chips located at different cross sections satisfy M < N.

7. The pumping module according to claim 4, wherein
along the axis of the crystal rod, at a plurality of cross sections perpendicular to the axis, a central wavelength difference M of a group of pump chips located at the same cross section and an average central wavelength difference N of different groups of pump chips located at different cross sections satisfy M < N.

8. A pumping module of a VCSEL side-pumped solid-state laser, comprising a pumping cavity and a crystal rod, wherein
the crystal rod is a working rod of the solid-state laser, and the pumping cavity is arranged around the crystal rod;
the pumping cavity comprises a heat sink and pump chips; the heat sink is a hollow cylinder; an even number of mounting surfaces are arranged on an inner surface of the heat sink; the mounting surfaces are flat surfaces and are parallel to an axis of the heat sink; within a cross section perpendicular to an axis of the crystal rod, projections of the plurality of mounting surfaces form a regular polygon; the mounting surfaces are even in number and include a plurality of pairs of mounting surfaces, each pair consisting of a mounting surface and a counterpart mounting surface, and the normal directions of the mounting surfaces and the counterpart mounting surfaces are offset from each other;
the pump chips are VCSEL chips which are arranged on the mounting surfaces;
within the cross section perpendicular to the axis, in light emission directions of the pump chips located on the mounting surfaces, a line passing through the center of the pump chip and the axis center of the crystal rod, and a line passing through the center of the pump chip on the counterpart mounting surface and the axis center, deviate from each other by a predetermined angle α; and the predetermined angle α is such that a distance between a normal line passing through the center of the pump chip on the mounting surface and a normal line passing through the center of the pump chip on the counterpart mounting surface is smaller than the diameter of the crystal rod.

9. The pumping module according to claim 8, wherein
the pump chips are top-emitting VCSEL chips.

10. The pumping module according to claim 9, further comprising a cooling tube, wherein
an axis of the cooling tube coincides with the axis of the crystal rod to surround the crystal rod and allows cooling gas or liquid to pass through to cool the crystal rod; and the cooling tube is made of a high-light-transmittance material.

11. The pumping module according to claim 10, wherein
the cooling tube has a polished outer surface or a frosted outer surface, and a roughness of the frosted outer surface is Ra0.1 to Ra80 µm.

12. The pumping module according to claim 11, wherein
the cooling tube has a polished outer surface or a frosted outer surface, and a roughness of the frosted outer surface is Ra0.2 to Ra50 µm.

13. The pumping module according to claim 9, wherein
along the axis of the crystal rod, at a plurality of cross sections perpendicular to the axis, a central wavelength difference M of a group of pump chips located at the same cross section and an average central wavelength difference N of different groups of pump chips located at different cross sections satisfy M < N.

14. The pumping module according to claim 11, wherein
along the axis of the crystal rod, at a plurality of cross sections perpendicular to the axis, a central wavelength difference M of a group of pump chips located at the same cross section and an average central wavelength difference N of different groups of pump chips located at different cross sections satisfy M < N.

15. A solid-state laser, comprising the pumping module according to any one of claims 1 to 14, an output mirror, and a reflector, wherein
the reflector and the output mirror are located on two opposite sides of the pumping module, and a resonance cavity is formed between the reflector and the output mirror; and
the output mirror is arranged in a light emission direction of the resonance cavity and is configured to output light.
